# EUROPEAN PATENT SPECIFICATION

(11) **EP 2 159 896 B1**
(45) Date of publication and mention of the grant of the patent: **30.09.2020**
(21) Application number: 09150715.2
(22) Date of filing: 16.01.2009
(51) Int. Cl.: H02J 1/10, H02J 3/38

(54) **Electrical system and method of operating such a system**
Elektrisches System und Verfahren zum Betrieb eines solchen Systems
Système électrique et procédé de fonctionnement d'un tel système

(30) Priority: 26.08.2008 NL 2001920
(43) Date of publication of application: 03.03.2010
(73) Proprietor: Femtogrid Energy Solutions B.V., 1086 XK Amsterdam (NL)
(72) Inventor: Schaacke, Robert, 2012 PA Haarlem (NL)
(74) Representative: De Vries & Metman

(56) References cited:
- DE-A1- 10 136 147
- JP-A- 2004 055 603
- JP-A- 2008 054 473
- US-A1- 2005 121 067
- US-A1- 2008 097 655
- US-B1- 6 369 462
- US-B1- 7 239 044
- MEINHARDT M ET AL: "Multi-string-converter with reduced specific costs and enhanced functionality", SOLAR ENERGY, PERGAMON PRESS. OXFORD, GB, vol. 69, 1 July 2001 (2001-07-01), pages 217-227, XP004303022, ISSN: 0038-092X, DOI: 10.1016/S0038-092X(01)00067-6

## Description

### FIELD OF THE INVENTION

The invention relates to the field of electrical power supply using an electrical system or electricity grid. In particular, the invention relates to an electrical system or grid that uses sustainable supply arrangements and is arranged for power distribution in e.g. a local environment.

### BACKGROUND OF THE INVENTION

In recent years, sustainable energy supply arrangements are expected to become used intensively in order to meet global environmental concerns as well as to anticipate on the expected shortage of conventional energy sources in the near future. As an example, a solar cell directly converting solar energy to electric energy has increasingly been expected to serve as a next-generation energy source in particular from a viewpoint of global environmental issues. Among various types of solar cells, such as a solar cell using a compound semiconductor or an organic material, a solar cell using silicon crystal is mainly employed these days. However, other material compositions have been investigated and may proof to be advantageously employed in the future.

At present, there are many problems that should be overcome before sustainable energy sources can be used widely as reliable and convenient manner of meeting energy demands. One of these problems is that such sources or arrangements are difficult to manage and control and, partly being due to the intrinsic unpredictable behaviour of such energy supply arrangements. Of course, such management and control should not be significantly destructive to the efficiency or add to the complexity of the system.

US 2008/097655 A1 discloses a method and system for providing a distributed local energy production system with high-voltage DC bus. In one embodiment, a system comprises a management unit to be interconnected via a network bus to a set of link modules, each link module coupled to a separate local energy production unit, each link module to include a Maximum Power Point Tracking (MPPT) step-up converter and a parameter monitoring unit to produce parameter data for the respective local energy production unit, and the local energy production units to be coupled to a high voltage power line to deliver produced electrical energy to a consumer of the energy; and the management unit to receive measured parameters from the link modules, and to send control signals to link modules to provide individual operational control of the local energy production units, the management unit to be coupled to one or more separate computers to provide the computers with access to the parameter data and control of the local energy production units.

DE 101 36 147 A1 discloses a device having a number of photovoltaic solar modules (10a-n) whose rated power fluctuates depending on parameters such as solar intensity, module temperature, solar technology and aging, and DC converters (20a-n) connected in parallel on the output side and to a central DC/AC converter (40) that converts the intermediate DC voltage from the converters into a sinusoidal voltage of defined frequency. Each solar module is electrically connected to an individual DC voltage converter that transforms the module output DC voltage into a significantly higher intermediate DC voltage, so that the solar modules are decoupled by their individual DC voltage converters.

US 6 369 462 B1 discloses a maximum power tracker that maximizes the power deliverable from a power source, such as a solar array, using increasing, decreasing and maintaining states controlled by a set point signal modulated by a dither signal for stabilized regular power tracking during under demand conditions and maximum power tracking during periods with over demand conditions of a load. Multiple converters and respectively maximum power trackers can be coupled in parallel using shared bus control signal for fault tolerant equalized power conversion through the converters.

### SUMMARY OF THE INVENTION

It is an object of the invention to provide an efficient electrical system of reduced complexity and a method for operating such a system for which system management is improved.

An electrical system comprising a DC voltage bus, at least one electrical energy supply arrangement or system and a power source is disclosed. The electrical energy supply arrangement is configured for supplying a DC voltage to the DC voltage bus. The power source is connected to the DC voltage bus and arranged for supplying power over the DC voltage bus to the electrical energy supply arrangement. The DC voltage bus is arranged for transporting the supplied DC voltage of the electrical energy supply arrangement. The electrical energy supply arrangement is configured for receiving power from the power source over the DC voltage bus and for supplying the DC voltage to the DC voltage bus only during receiving the power from the power source over the DC voltage bus.

Furthermore, a method of operating such an electrical system is disclosed. The method comprises the step of supplying the DC voltage from the electrical energy supply arrangement over the DC voltage bus only if the power is received from the power source at the electrical energy supply arrangement over the DC voltage bus. In particular, it may be monitored if power is received from the power source over the DC voltage bus in the electrical energy supply arrangement and to disconnect the electrical energy supply arrangement from the DC voltage bus such that no DC voltage is supplied to the DC voltage bus if power is monitored to be absent on said DC voltage bus.

The parallel DC voltage bus for transporting the supplied DC voltage constitutes a simple and efficient means for collecting and transporting the generated energy. The electrical energy supply arrangements, that may be connected in parallel to the DC voltage bus, may simply output a DC voltage and do not individually need a DC/AC voltage converter. Whether or not the electrical energy supply arrangements generate energy (which is unpredictable for sustainable energy supplies), power for such DC voltage bus, such that these arrangements are always available for receiving and processing management and control commands (e.g. relating to maintenance, diagnosis, communication) as instructed centrally over the DC voltage bus. By disconnecting the power source from the DC voltage bus, the arrangements are no longer able to supply power to the DC voltage bus, which also improves management and control by providing for safety in cases of e.g. maintenance of the system. Such a method and system are particularly advantageous for sustainable energy sources as defined in claim 3 as a result of the uncertainty of delivering electrical energy for such sources.

It should be appreciated that the electrical energy supply arrangement may contain a connecting device for connection to the DC voltage bus. The connecting device may be integrated with a supply device (e.g. a photovoltaic module) or be mountable to such a device as a module. The connecting device may contain one or more components (e.g. a switch, a microcontroller etc.) that enable the electrical energy supply arrangements to perform the operations described in the present application, examples of which are disclosed below.

It should also be appreciated that the power supply connection may be physically separated from the voltage bus over which the DC voltage is transported. The DC voltage bus comprises a three-wire bus containing one wire related to security zero voltage.

The embodiment of the invention as defined in claim 2 provides the advantage that also electrical energy demand arrangements connected to the DC voltage bus can be centrally controlled over the DC voltage bus.

The embodiment of the invention as defined in claim 4 provides the advantage that the DC voltage of several electrical energy supply arrangements can be collectively converted to an AC voltage by a single DC/AC converter connected to the bus. Advantageously, the power source of such a converter can be used for providing power over the DC voltage bus to the electrical energy supply arrangements and/or the electrical energy demand

The embodiment of the invention as defined in claim 6 provides local intelligence in an electrical energy supply arrangement that is responsible for determining whether or not the DC voltage should be supplied to the DC voltage bus in response to monitoring whether power is received over the bus from the power supply. As an example, such local intelligence comprises a controller monitoring the power connection of the bus and a switch that can be controlled by the controller and that is arranged for connecting or disconnecting the electrical energy supply arrangement from the connection of the bus over which the DC voltage is supplied in response to the monitored power.

Even if power from the power source is available to the electrical energy supply arrangement, the electrical energy supply arrangement does not always supply a DC voltage to the DC voltage bus. Of course, this occurs when no energy is generated at a sustainable energy source (e.g. for a wind energy source when no wind blows). However, as defined in claims 7 and 14, the electrical energy supply arrangement (and also the electrical energy demand arrangement) may also comprise a sensor for configured for sensing the DC voltage state of the DC voltage bus and to adapt the energy supply, respectively, the energy demand to the sensed DC voltage state. This sensing is particularly advantageous for sustainable energy supply arrangements as such arrangements are characterized by unpredictable behaviour. The DC voltage state of the DC voltage bus is directly visible for both the energy supply arrangements and the DC demand arrangements by means of the sensor. If the DC voltage of the bus is sensed to be above a pre-defined first threshold, energy supply arrangement is configured to not supply the DC voltage (even though the power is supplied to the energy supply arrangement. If the sensed DC voltage of the DC voltage bus is below a pre-defined second threshold, an energy demand arrangement will not draw DC voltage from the DC voltage bus. In between these thresholds, energy supply arrangements and energy demand arrangements are configured to supply, respectively, draw a DC voltage from the DC voltage bus provided that power is received signals whether or not a DC voltage can be supplied or drawn from the DC voltage bus if power is received by the respective supply and demand arrangements.

The embodiment of the invention as defined in claim 8 provides for a suitable connector having a last-make, firstbreak configuration for the contact of the power supply. Such an arrangement makes sure that the electrical system only operates upon connection of all contacts of the connector.

The embodiment of the invention as defined in claim 9 relates to a special type of sustainable energy supply arrangements, viz. photovoltaic modules. By providing the first and second photovoltaic module in parallel within a string of photovoltaic modules, a reduced efficiency of one or both of these parallel connected photovoltaic modules has less influence on the total efficiency of the complete string of photovoltaic modules as compared to a string wherein all photovoltaic modules are electrically connected in series. Such parallel connection is easily obtained using the connecting device. Moreover, the DC voltage parallel bus for the modules to release the generated DC photovoltaic energy obviates the need for a DC/AC converter for each module. From the perspective of installing the arrangement, the DC voltage bus reduces the amount of cabling typically required for prior art series connected photovoltaic modules. DC voltages are simple and efficient in operation as compared to AC voltages.

The embodiment of the invention as defined in claim 10 provides an efficient means for boosting the first DC voltage (e.g. 0-100V, particularly 20-80 V) provided by each of the photovoltaic modules to a second DC voltage (e.g. 400 V) for the DC voltage bus. The efficiency gain is of the order of 2-5%. The switched-coil arrangement of the transformer, sometimes also referred to as switched auto-transformer arrangement, provides for reduced inductive leakage and thus considerably boosts the efficiency of the DC-DC voltage conversion. In particular, the coils may be flat coils comprising a planar ferrite core. The switch may be a (MOS)FET or a IGBT for further reducing losses. The ciency, e.g. by operating the switch with a combined frequency and pulse-width modulation switch scheme.

The embodiment of the invention as defined in claim 11 provides for an appropriate communication connection with the energy supply arrangement using the power connection. Since the operation of the electrical energy supply arrangement depends on this power connection, an operating communicative connection is always available. Communication can e.g. be implemented by modulating a DC voltage supply signal over the power connection line.

Hereinafter, embodiments of the invention will be described in further detail. It should be appreciated, however, that these embodiments may not be construed as limiting the scope of protection for the present invention.

### BRIEF DESCRIPTION OF THE DRAWINGS

In the drawings:
FIG. 1 is a schematic illustration of a system of energy supply arrangements and energy demand arrangements connected to a DC voltage bus;
FIG. 2 is a schematic illustration of an sustainable energy supplier of FIG. 1 comprising a photovoltaic arrangement of photovoltaic modules connected to a DC voltage bus;
FIG. 3 is a schematic illustration of photovoltaic modules and connecting devices for connecting the modules to the DC voltage bus;
FIGS. 4-6 illustrate various embodiments of parts of electric circuits for increasing the DC voltage of the photovoltaic module;
FIG. 7 provides a schematic example of connecting a photovoltaic module to a DC voltage bus comprising a DC/AC converter; and
FIGS. 8A and 8B provide operation diagrams of a photovoltaic module and a DC/AC converter of the system of FIG. 1.

### DETAILED DESCRIPTION OF THE DRAWINGS

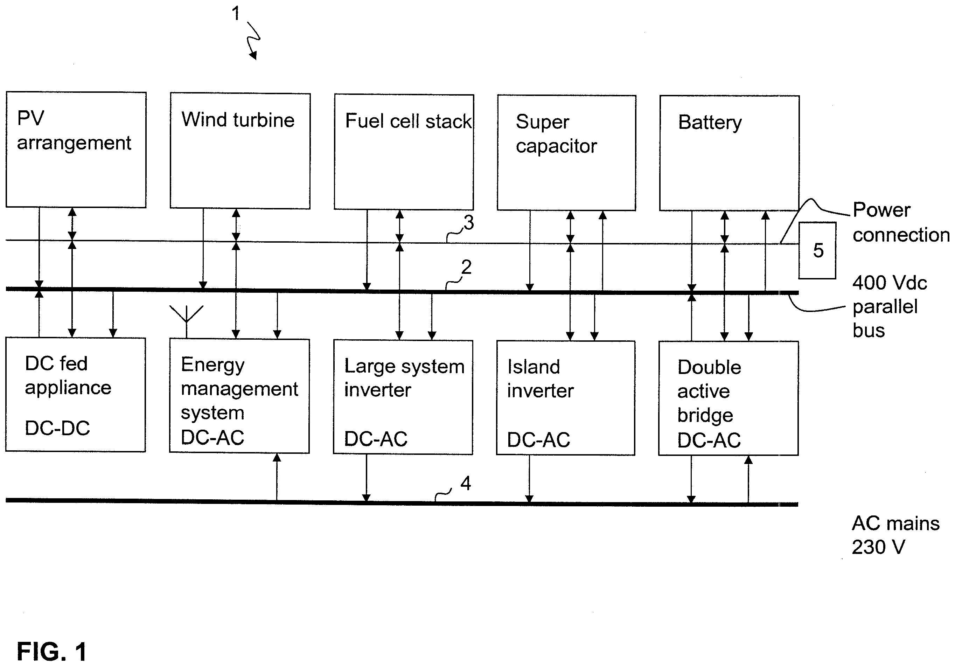

FIG. 1 is a schematic illustration of an electrical system 1 comprising a plurality of energy supply arrangements (devices) or sources and energy demand arrangements (devices) and a DC voltage bus 2 to which the energy supply arrangements and energy demand arrangements are connected. Furthermore, the system 1 comprises a power connection 3 connected to the energy supply arrangements and energy demand arrangements as well. Power connection 3 may be separate or be integrated in the DC voltage bus 2 and is used for providing power to and/or for communication with the energy supply and energy demand arrangements as will be explained in further detail below.

Energy supply arrangements preferably comprise sustainable energy supply arrangements, including photovoltaic arrangements, wind energy arrangements and/or fuel cell arrangements. The present application primarily focuses on the photovoltaic supply arrangements comprising one or more solar cell modules.

Energy demand arrangements include devices that may operate on a DC voltage input of the DC voltage bus, including computers, light sources, televisions etc. Generally, devices comprising a switched mode power supply are capable of operating with a DC voltage. Operation of devices at DC voltages saves power, while particular components (e.g. capacitors) can be saved or have an increased life time.

Other devices that operate on the DC voltage of the DC voltage bus include an energy management system, a large inverter system, an island inverter system (for stand alone AC power supply, typically used for providing AC power locally) and a double active DC/AC bridge. The energy management system is configured for managing at least one of the energy supply and demand arrangements either via communication over the power connection 3 or wirelessly. In particular, the energy management system may be used to overrule decisions made internally by the energy supply or demand arrangements, e.g. with regard to whether an arrangement may supply and/or demand energy from the voltage bus. The inverters are used for converting the DC volt-bridge may also convert AC voltage of the AC mains grid to the DC voltage bus as a backup in case energy suppliers are not capable of supplying sufficient power to the DC bus.

However, the electricity grid system 1 also comprises energy supply arrangements configured for temporarily storing electric energy and for releasing the energy at a later stage for the energy demand arrangements. In FIG. 1, these energy supply arrangements include a super capacitor and a battery. The super capacitor may be used for supplying instantaneous peak energy demands from an energy demand arrangement during a limited period of time.

The DC voltage bus 2 of the electricity grid system 1 is capable of assuming a plurality of DC voltage states. The energy supply arrangements and energy demand arrangements are configured for sensing the DC voltage state of the DC voltage bus 2 and to adapt the energy supply, respectively, the energy demand to the sensed DC voltage state. This sensing is particularly advantageous for sustainable energy supply arrangements as such arrangements are characterized by unpredictable behaviour. The DC voltage state of the DC voltage bus 2 is directly visible for both the energy supply arrangements and the DC demand arrangements. The decision to supply or demand energy from the DC voltage bus may be overruled by the energy management system as illustrated in FIG. 1.

As an example, an energy supply arrangement may comprise a microprocessor connected such that the DC voltage of the DC voltage bus can be detected and compare the detected voltage with pre-set voltage levels. As an example, energy may be supplied if the DC voltage of the DC voltage bus 2 is detected to be between a maximum DC voltage of e.g. 400 Vdc and a minimum DC voltage of e.g. 360 Vdc. As another example, an energy demanding arrangement may be configured not to demand energy from the DC voltage bus 2 if the detected DC voltage is below a minimum DC voltage of e.g. 360 Vdc. As yet another example, an energy supply arrangement configured for storing and releasing energy may be programmed to release energy as soon as the DC voltage of the ergy supply arrangements and energy demand arrangement requires a dedicated inverter dependent on the type of supply or demand arrangement.

Also, if the energy demand arrangements have an energy surplus, this energy can be provided back to the DC voltage bus 2. Of course, such energy demand arrangements must be configured for sensing the DC voltage state of the DC voltage bus 2 and for supply the energy surplus to the DC voltage bus in dependence of the sensed DC voltage state as described above for an energy supply arrangement. This is generally not possible for an AC mains grid due to very strict requirements and complicated electronics for energy feedback to such an AC mains grid.

The DC voltage bus 2 may transport a power of 4-8 kW for a string of PV modules 10. Such a voltage bus is particularly useful in a local environment, such as houses, ships, offices, etc. Use of the AC mains grid can be minimized if such a DC voltage bus 2 is provided.

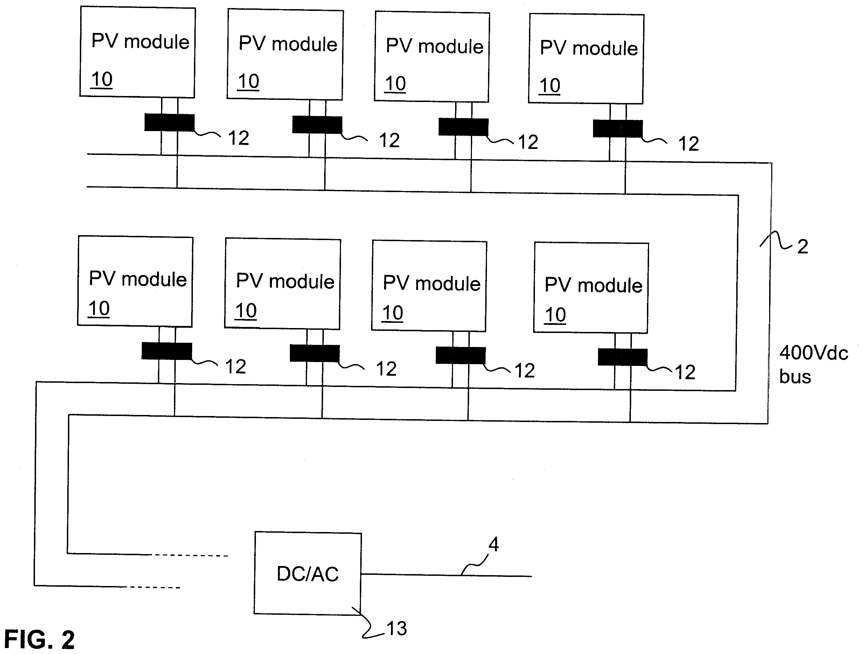

Generally, an electrical energy supply arrangement, such as one or more PV modules 10 (see FIG. 2) is configured for supplying a DC voltage to the DC voltage bus 2. A power source 5 is connected to the DC voltage bus 2, in particular to the power connection, and arranged for supplying power over the power connection of the DC voltage bus to the electrical energy supply arrangements and electrical energy demand arrangements. The DC voltage bus 2 is arranged for transporting the supplied DC voltage of the electrical energy supply arrangement. The electrical energy supply arrangement is configured for receiving power from the power source over the power connection 3 of the DC voltage bus and for supplying the DC voltage to the DC voltage bus 2 only during receiving the power from the power source 5.

The parallel DC voltage bus 2 for transporting the supplied DC voltage constitutes a simple and efficient means for collecting and transporting the generated energy. The electrical energy supply arrangements, that may be connected in parallel to the DC voltage bus 2, may simply output a DC voltage and do not individually need a DC/AC voltage converter. Whether or not the unpredictable for sustainable energy supplies), power for such arrangements is always available from the power source 5 via the power connection of the DC voltage bus 2, such that these arrangements are always available for receiving and processing management and control commands (e.g. relating to maintenance, diagnosis, communication) as instructed centrally over the DC voltage bus 2. By disconnecting the power source 5 from the power connection of the DC voltage bus 2, the arrangements are no longer able to supply power to the DC voltage bus 2, which also improves management and control by providing for safety in cases of e.g. maintenance of the system.

The following explanation will describe the operation in further detail with reference to a photovoltaic energy supply arrangement.

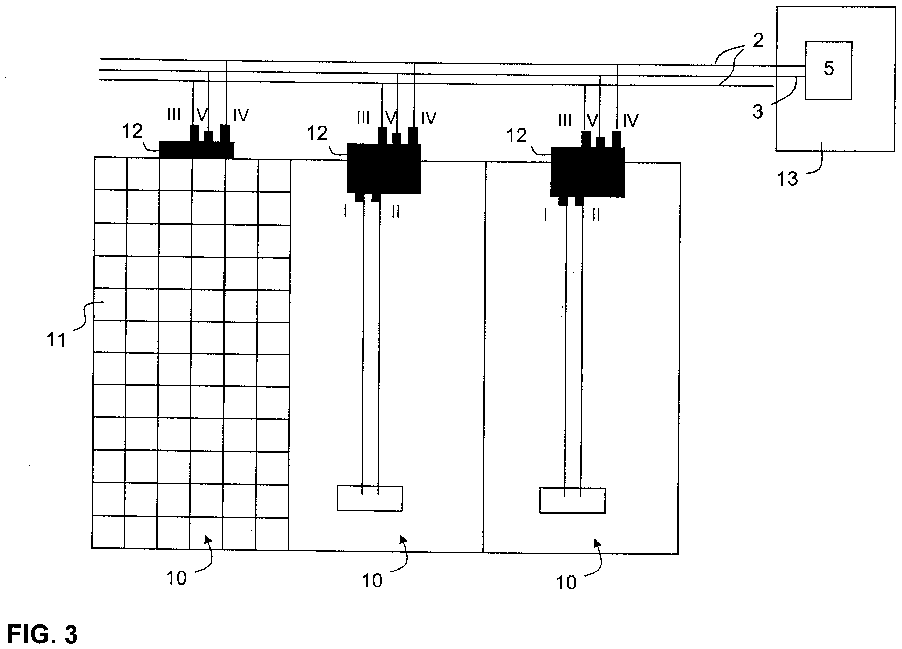

FIGS. 2 and 3 provide schematic illustrations of a photovoltaic (PV) energy supply arrangement comprising a plurality of photovoltaic modules 10 and a DC voltage bus 2. The power connection 3 is integrated in the DC voltage bus 2 (see FIG. 3). Photovoltaic modules 10 each comprise a plurality of solar cells 11 and are connected to the DC voltage bus 2 using connecting devices 12. Photovoltaic modules 10 are connected to the DC voltage bus 2 such that the modules are arranged in parallel. By providing the photovoltaic modules 10 in parallel within a string of photovoltaic modules, a reduced efficiency of one of these parallel connected photovoltaic modules 10 has less influence on the total efficiency of the complete string of photovoltaic modules as compared to a prior art arrangement wherein all photovoltaic modules in a string are connected in series.

In particular, each PV module 10 is provided with a connecting device 12. A connecting device 12 comprises first and second contacts I, II for connecting to a PV module and third and fourth contacts III, IV for connecting the PV modules to the DC voltage bus 2 such that mutual PV modules 10 are electrically connected in parallel. A contact V is used for connecting to the power connection 3. Contact V is shorter arranged as a last-would be made shorter than pins III and IV in order for a connection to be established for contact V after connection of contacts III and IV and to disconnect before disconnection of contacts III and IV.

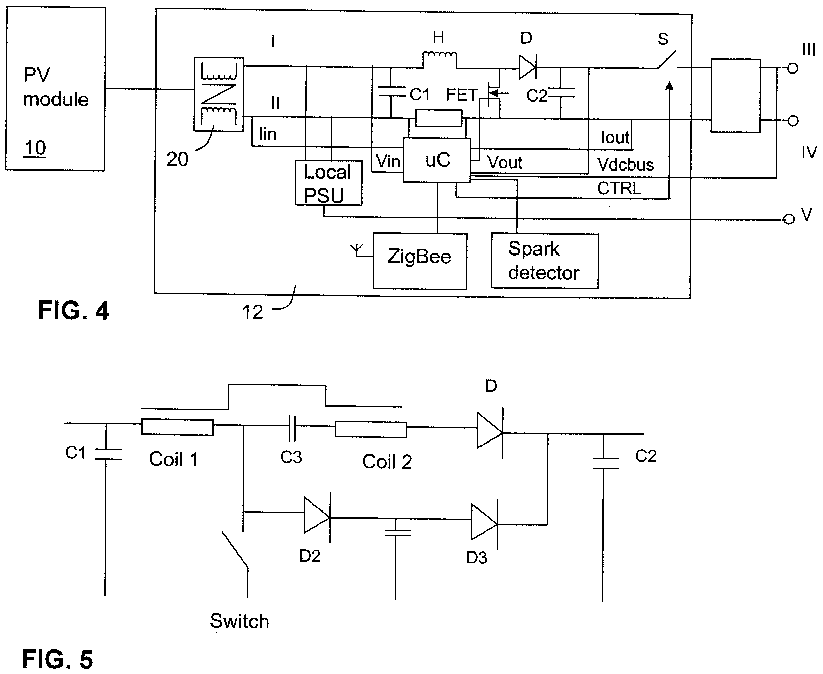

Generally, a PV module 10 generates a DC voltage (typically between 0-100 V, e.g. between 20-80 V) in response to radiation received by the solar cells 11. The connecting device 12 boosts the voltage to the DC voltage of the DC voltage bus 2, e.g. to 400 Vdc as will be explained in further detail with reference to FIGS. 4-7.

Connecting device 12 may be a separate module that can be attached to a PV module 10, but may also be integrated in the PV module 10.

The DC voltage bus 2 for the modules 10 to release the generated DC photovoltaic energy obviates the need for a DC/AC converter for each module 10 if an AC voltage is to be supplied. A single DC/AC converter 13, e.g. the large system inverter, the island inverter or the dual bridge inverter of FIG. 1, may be connected to the DC voltage bus 2 in order to convert 400Vdc to 230Vac of the mains grid. The DC parallel voltage bus 2 reduces the amount of cabling typically required for prior art series connected photovoltaic modules. Power source 5 may be contained within the DC/AC converter 13.

The connecting device 12 is employed for connecting PV module 10 to the DC voltage bus 2 in parallel with another PV module 10. Connecting device 12 is also used, amongst other functions, for boosting the voltage of the PV module 10 to a suitable voltage for the parallel voltage bus 2.

In FIG. 4, PV module 10 generates e.g. a DC voltage of 24 V that should be boosted to 400 Vdc. High voltages typically enable lower currents and, therefore, lower losses.

PV module 10 is connected to connecting device 12 using contacts I and II. A transformer 20 is provided for EMC shielding purposes. The DC voltage is increased using a first capacitor C1 and a second capacitor C2 connected in parallel using an inductive coil H and a diode D. A switch, here a field capacitor C1 to the second capacitor C2 to obtain the DC voltage required for the voltage bus 2 using contacts III and IV. Switching is performed under the control of a microprocessor uC.

Microprocessor uC monitors the input voltage Vin and the input current Iin for power point tracking purposes. Microprocessor uC also monitors output voltage Vout and output current lout for monitoring output power and for security purposes. Microprocessor uC also monitors the DC voltage of the DC voltage bus 2, Vdcbus in order to control the switching of switch S. If the voltage of the bus 2 is 400Vdc, no further energy is supplied as determined by preset voltage levels in the microprocessor uC.

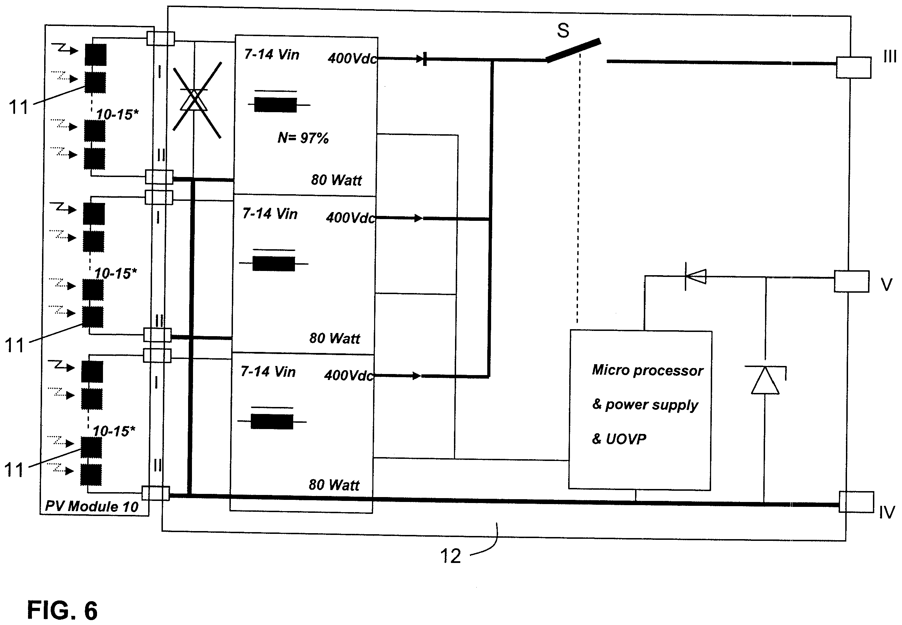

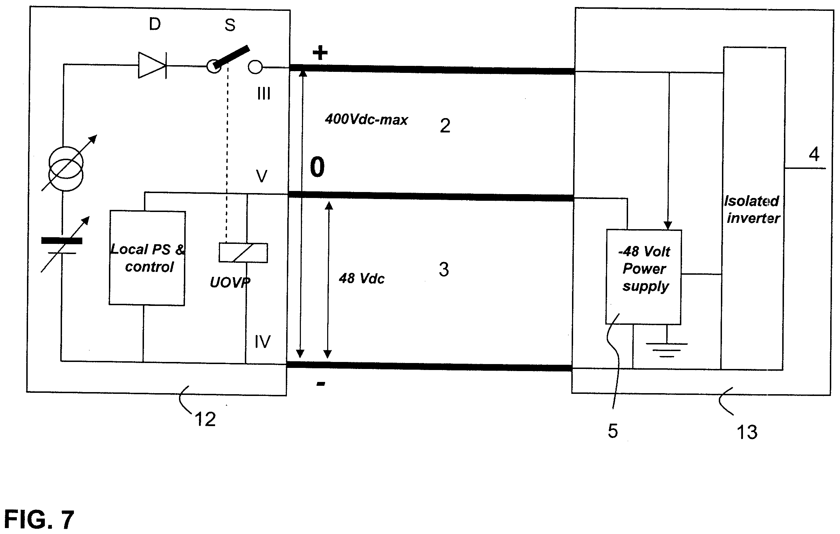

The connecting device 12 operates using a local power supply unit, designated local PSU, that is connected via V connected to power supply connection 3 as depicted in further detail in FIGS. 6 and 7. Local PSU only powers the connecting device 12 if it receives an appropriated voltage over contacts IV, V, e.g. -48V. Otherwise, switch S is open and no energy is supplied to voltage bus 2. Switch S may either be instructed to open from the Local PSU or from the microcontroller uC.

The voltage boost efficiency that can be obtained with the embodiment of the connecting device of FIG. 4 is about 80%.

A further efficiency gain can be obtained by using the electric circuit of FIG. 5 using a split coil transformer arrangement instead of the integral coil H of FIG. 4. The coils "Coil 1" and "Coil 2" may be flat core coils comprising a planar ferrite core separated by a capacitor C3. The planar components allow integration of the components behind the PV modules 2. A switch is again provided to pump charge from capacitor C1 to capacitor C2 and can be controlled using a processing device uC (not shown in FIG. 5, see FIG. 4.) The current path between Coil 1 and capacitor C2 via diodes D2, D3 allows remaining energy to flow to the capacitor C2 in the open state of the switch. The control of the switch can be used to further boost the efficiency, e.g. by operating the switch with a combined frequency and pulse-width modulation switch scheme. A typical switching ther perform the same monitoring functions as discussed with reference to FIG. 4.

The voltage boost efficiency that can be obtained with the planar ferrite core split coil transformer is about 97 % at 180W.

It is noted that other methods for increasing the DC voltage of the PV modules 10 may be used. As an example, a switched capacitor arrangement may be employed. However, such an arrangement generally requires further measures to be taken for controlling the output voltage and the life expectancy of the capacitors at the relevant power is generally too low.

Several further functions can be implemented in the connecting devices 12 of FIGS. 4 and 5. Of course, such functions require power and may decrease the efficiency of the PV module/connecting device 12 combination.

Microcontroller uC may comprise a power point tracker by measuring Vin and Iin for the PV module 10 to monitor whether the obtained power is within the optimum range to obtain the optimum photovoltaic conversion efficiency.

Furthermore, sparks can be formed in the photovoltaic modules 12, particularly at the contacts I, II and III, IV in case of e.g. bad contact. Sparks may lead to hotspots and subsequently may lead to fire. The temperature (e.g. of the first and second contacts I, II of the connecting device) and/or other characteristics can be measured using a spark detector in combination with microcontroller uC as depicted in FIG. 4. The spark detector is provided within each connecting device 12. The spark detector comprises a circuit that is configured for detecting sparks in the main current loop of a single PV module 10.

This measurement can be communicated to an external control system (e.g. the energy management system in FIG. 1 or another monitoring system) and an individual photovoltaic module 10 or connection device 12 may be preventively disabled to avoid fire. The instruction to disable the photovoltaic module 10 may originate internally, e.g. from the microprocessor, of externally, e.g. from the monitoring system. The disablement of the efficiency of the string comprising the disabled photovoltaic module 10 as a result of the parallel connection to the DC voltage bus 2.

The measurements and other data (current, voltage, power, status) may be transmitted wirelessly for each photovoltaic module 10 to an external system (a central gateway), using e.g. ZigBee. Clusters of PV modules 10/connecting devices 12 may communicate with a particular central gateway. The connection devices 12 may comprise a wireless transceiver for transmitting data and receiving commands from the external system. Photovoltaic modules 10 and/or connecting devices 12 of these modules 10 may also communicate with each other by building short range mesh networks. The performance of a single PV module 10 can be monitored and, if need be, being serviced.

The microcontroller uC, measurement circuitry, the spark detector and/or the wireless transmitter or transceiver may also be part of the connecting device 12 of FIG. 5.

The microcontroller uC, measurement circuitry, the spark detector and/or the wireless transmitter or transceiver may be provided on a printed circuit board in the connecting device 12.

It should be noted that instead of a microcontroller, other controllers can be used.

FIG. 6 shows a block diagram of a PV module 10 and a connecting device 12, wherein connecting device 12 provides multiple contacts I, II for batches of solar cells 11 in parallel. Each batch comprises 10-15 solar cells 11 to provide a DC voltage of 7-14 Vdc. This DC voltage is boosted to 400 Vdc for each batch separately using the split coil transformer arrangement of FIG. 5. As a consequence, it is no longer required to provide a by-pass with a diode as is regularly observed in prior art PV modules, indicated by the cross through the diode in FIG. 6. By avoiding the need of a by-pass diode, conversion efficiency is increased and a potential source of defects and fire is omitted.

The microprocessor controls a switch S determining whether the boosted DC voltage of 400 V is supplied to the condevice 12 is powered via contacts IV and V from e.g. a power source 5 in the DC/AC converter 13 connected to the power connection 3 and the 0 volts connection of the DC voltage bus 2 as illustrated in FIG. 7 for an integral PV module 10. As an example, contact IV is at a potential of -48V and contact V at a potential around 0V (thus, if the DC voltage bus should be at 400V, contact III is at a potential of 352 V). Switch S is open by default if no voltage is applied to contacts IV and V for the connecting device 12, i.e. no power is provided over power connection 3.

The power for the local power supply is obtained from the DC/AC converter 13 as illustrated in FIG. 7 via the DC voltage bus 2, more particularly using the line related power connection 3. This power connection can also be used for communication and security (e.g. UOVP: under-and-over voltage protection). For communication (e.g. Ethernet) between the connecting module 12 and an inverter 13, the DC voltage of -48 can be modulated. Also, contact V may also be used as a security contact, e.g. last make, first break, to disable the connecting device 12 until contacts III, IV are securely connected. Contact V may be a separate pin within e.g. contact III or IV.

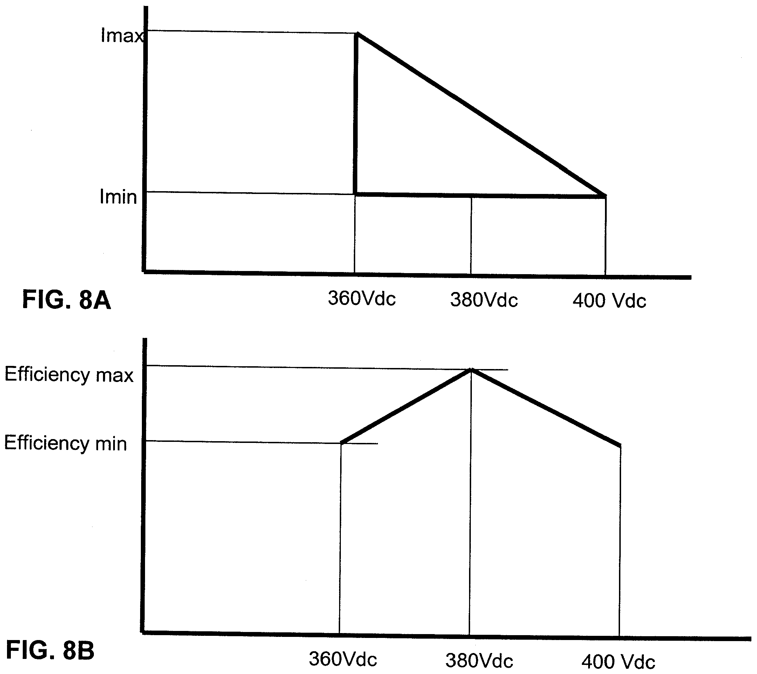

FIGS. 8A and 8B illustrate operating diagrams for the PV module 10/connecting device 12 and the inverter 13, respectively. If the DC voltage of the DC voltage bus 2 amounts to 400 Vdc, the maximum voltage is reached and energy is available for energy demanding arrangements. This state of the DC voltage bus is sensed by the energy demanding arrangements. These energy demanding arrangements may comprise a microprocessor to sense this state and to control a switch for connecting to the DC voltage bus 2 for receiving the DC voltage. On the other hand, if the DC voltage bus is 400V, the energy supplying arrangements sense that no further power is required for the bus, such that microcontroller uC of e.g. FIG. 6 opens switch S and energy is no longer supplied to the DC voltage bus 2 from the PV module 10 (provided that the super capacitor and battery are also full). If the voltage on the DC voltage bus 2 is 380 V, both energy energy to, respectively, draw energy from the DC voltage bus 2 as signalled by the DC voltage state of the DC voltage bus 2 as sensed by these arrangements. If the DC voltage of the bus 2 is 360V, the load of bus 2 is maximum and energy demand arrangements sense that power can no longer be drawn from DC voltage bus 2. If power is needed, the AC/DC double bridge converter of FIG. 1 may be used to obtain a DC voltage at the DC voltage bus 2 from the AC mains grid 4.

As can be observed from FIG. 8B, the DC/AC conversion of converter 13 is designed to be maximum at 380V. Of course, the converter may also be designed to have maximum conversion over the entire range of 360-400V.

## Claims

1. An electrical system (1) comprising:
- a DC voltage bus (2);
- at least one electrical energy supply arrangement configured for supplying a DC voltage to said DC voltage bus, wherein
said DC voltage bus is arranged for transporting said supplied DC voltage of said electrical energy supply arrangement;
**characterized in that**
- the system further comprises a power source (5) connected to said DC voltage bus and arranged for supplying power over said DC voltage bus to said electrical energy supply arrangement,wherein said electrical energy supply arrangement is configured for receiving power from said power source over said DC voltage bus and for supplying said DC voltage to said DC voltage bus only during receiving said power from said power source over said DC voltage bus.

2. The electrical system according to claim 1, further comprising an electrical energy demand arrangement configured for demanding a DC voltage from said DC voltage bus (2), wherein said electrical energy demand arrangement is configured for receiving power from said power source (5) over said DC voltage bus and for demanding said DC voltage from said DC voltage bus only during receiving said power.

3. The electrical system according to claim 1 or 2,
wherein said electrical energy supply arrangement comprises a sustainable energy source.

4. The electrical system according to one or more of the preceding claims, wherein said system comprises a DC/AC converter connected to said DC voltage bus and arranged for receiving said DC voltage over said DC voltage bus and for converting said DC voltage to an AC voltage.

5. The electrical system according to claim 4, wherein said power source is a power source of the DC/AC converter.

6. The electrical system according to one or more of the preceding claims, wherein said electrical energy supply arrangement comprises a controller configured for monitoring said power received from said power source over said DC voltage bus and for disconnecting said electrical energy supply arrangement from said DC voltage bus such that no DC voltage is supplied to said DC voltage bus if power is monitored to be absent on said DC voltage bus.

7. The electrical system according to one or more of the preceding claims, wherein said electrical energy supply arrangement comprises a sensor configured for sensing a DC voltage state of said DC voltage bus and wherein said electrical energy supply arrangement is configured for supplying said DC voltage to said DC voltage bus in dependence of said sensed DC voltage state.

8. The electrical system according to one or more of the preceding claims, said DC voltage bus comprising separate connections for supplying said DC voltage and for carrying said power, wherein said electrical energy supply arrangement comprises a connector for connecting to said DC voltage bus, said connector comprising a contact being configured, upon connection, to establish contact with said connection for carrying said power after connecting to said connections for supplying said DC voltage and to disconnect from said connection for carrying said power before disconnecting from said connections for supplying said DC voltage.

9. The electrical system according to one or more of the preceding claims, wherein said electrical energy supply arrangement comprises a first photovoltaic module and a second photovoltaic module in a string, said first photovoltaic module and second photovoltaic module being electrically connected in parallel and arranged to provide said DC voltage to said DC voltage bus.

10. The electrical system according to one or more of the preceding claims, wherein said electrical energy supply arrangement comprises a DC step-up voltage converter for providing said DC voltage to said DC voltage bus, said DC step-up voltage converter optionally comprising a transformer with a switched-coil arrangement.

11. The electrical system according to one or more of the preceding claims, wherein said electrical energy supply arrangement is configured for communicating over said DC voltage bus using a connection for receiving said power.

12. A method for operating an electrical system (1) comprising:
- a DC voltage bus (2);
- an electrical energy supply arrangement configured for supplying a DC voltage to said DC voltage bus; characterised
- a power source (5) connected to said DC voltage bus and arranged for supplying power over said DC voltage bus to said electrical energy supply arrangement; the method comprising the step of:
supplying said DC voltage from said electrical energy supply arrangement over said DC voltage bus only if said power is received from said power source at said electrical energy supply arrangement over said DC voltage bus.

13. The method according to claim 12, further comprising the steps of
- sensing a DC voltage state of said DC voltage bus;
- supplying said DC voltage to said DC voltage bus in dependence of said sensed DC voltage state.

14. The method according to claims 12 or 13, further comprising the step of communicating over said DC voltage bus with said electrical energy supply arrangement using a connection of said DC voltage bus for receiving said power.

## Patentansprüche

1. Elektrisches System (1) aufweisend:
- einen DC-Spannung-Bus (2);
- mindestens eine elektrische Energieeinspeisungseinrichtung, die konfiguriert ist, eine Gleichspannung in den DC-Spannung-Bus einzuspeisen, wobei der DC-Spannung-Bus eingerichtet ist, um die eingespeiste DC-Spannung der elektrischen Energieeinspeisungseinrichtung zu transportieren;
**dadurch gekennzeichnet, dass**
- das System ferner eine Stromquelle (5) aufweist, die mit dem DC-Spannung-Bus verbunden ist und eingerichtet ist, über den DC-Spannung-Bus Strom in die elektrische Energieeinspeisungseinrichtung einzuspeisen, wobei die elektrische Energieeinspeisungseinrichtung konfiguriert ist, Strom aus der Stromquelle über den DC-Spannung-Bus zu empfangen und die DC-Spannung in den DC-Spannung-Bus nur dann einzuspeisen, während sie Strom aus der Stromquelle über den DC-Spannung-Bus empfängt.

2. Elektrisches System nach Anspruch 1, ferner aufweisend eine elektrische Energienachfrageeinrichtung, die konfiguriert ist, eine DC-Spannung aus dem DC-Spannung-Bus (2) nachzufragen, wobei die elektrische Energienachfrageeinrichtung konfiguriert ist, Strom aus der Stromquelle (5) über den DC-Spannung-Bus zu empfangen und die DC-Spannung aus dem DC-Spannung-Bus nur dann nachzufragen, während sie den Strom empfängt.

3. Elektrisches System nach Anspruch 1 oder 2, wobei die elektrische Energieeinspeisungseinrichtung eine erneuerbare Energiequelle aufweist.

4. Elektrisches System nach einem oder mehreren der vorstehenden Ansprüche, wobei das System einen DC/AC-Wandler aufweist, der mit dem DC-Spannung-Bus verbunden ist und eingerichtet ist, die DC-Spannung über den DC-Spannung-Bus zu empfangen und die DC-Spannung in eine AC-Spannung umzuwandeln.

5. Elektrisches System nach Anspruch 4, wobei die Stromquelle eine Stromquelle des DC/AC-Wandlers ist.

6. Elektrisches System nach einem oder mehreren der vorstehenden Ansprüche, wobei die elektrische Energieeinspeisungseinrichtung eine Steuerung aufweist, die konfiguriert ist, den aus der Stromquelle über den DC-Spannung-Bus empfangenen Strom zu überwachen und die elektrische Energieeinspeisungseinrichtung von dem DC-Spannung-Bus zu trennen, so dass keine Spannung in den DC-Spannung-Bus eingespeist wird, wenn eine Abwesenheit von Strom an dem DC-Spannung-Bus festgestellt wird.

7. Elektrisches System nach einem oder mehreren der vorstehenden Ansprüche, wobei die elektrische Energieeinspeisungseinrichtung einen Sensor aufweist, der konfiguriert ist, einen DC-Spannungszustand des DC-Spannung-Busses zu detektieren, und wobei die elektrische Energieeinspeisungseinrichtung konfiguriert ist, in Abhängigkeit von dem detektierten DC-Spannungszustand die DC-Spannung in den DC-Spannung-Bus einzuspeisen.

8. Elektrisches System nach einem oder mehreren der vorstehenden Ansprüche, wobei der DC-Spannung-Bus separate Verbindungen zum Einspeisen der DC-Spannung und zum Transportieren des Stroms aufweist, wobei die elektrische Energieeinspeisungseinrichtung einen Verbinder zum Verbinden mit dem DC-Spannung-Bus aufweist, wobei der Verbinder einen Kontakt aufweist, der konfiguriert ist, bei Verbindung
einen Kontakt mit der Verbindung zum Transportieren des Stroms herzustellen nach Verbinden mit den Verbindungen zum Einspeisen der DC-Spannung, und
von der Verbindung zum Transportieren des Stroms zu trennen vor Trennen von den Verbindungen zum Einspeisen der DC-Spannung.

9. Elektrisches System nach einem oder mehreren der vorstehenden Ansprüche, wobei die elektrische Energieeinspeisungseinrichtung ein erstes Photovoltaik-Modul und ein zweites Photovoltaik-Modul in einer Reihe aufweist, wobei das erste Photovoltaik-Modul und das zweite Photovoltaik-Modul elektrisch parallel miteinander verbunden sind und eingerichtet sind, dem DC-Spannung-Bus die DC-Spannung bereitzustellen.

10. Elektrisches System nach einem oder mehreren der vorstehenden Ansprüche, wobei die elektrische Energieeinspeisungseinrichtung einen DC-Aufwärtsspannungswandler aufweist, um dem DC-Spannung-Bus die DC-Spannung bereitzustellen, wobei der DC-Aufwärtsspannungswandler optional einen Transformator mit einer Schaltspule-Einrichtung aufweist.

11. Elektrisches System nach einem oder mehreren der vorstehenden Ansprüche, wobei die elektrische Energieeinspeisungseinrichtung konfiguriert ist, über den DC-Spannung-Bus unter Verwendung einer Strom empfangenden Verbindung zu kommunizieren.

12. Verfahren zum Betreiben eines elektrischen Systems (1) aufweisend:
- einen DC-Spannung-Bus (2);
- eine elektrische Energieeinspeisungseinrichtung, die konfiguriert ist, eine Gleichspannung in den DC-Spannung-Bus einzuspeisen;
**gekennzeichnet durch**
- eine Stromquelle (5), die mit dem DC-Spannung-Bus verbunden ist und eingerichtet ist, Strom über den DC-Spannung-Bus in die elektrische Energieeinspeisungseinrichtung einzuspeisen;
wobei das Verfahren den folgenden Schritt aufweist:
Ausspeisen der DC-Spannung aus der elektrischen Energieeinspeisungseinrichtung über den DC-Spannung-Bus nur dann, wenn der Strom aus der Stromquelle über den DC-Spannung-Bus an der elektrischen Energieeinspeisungseinrichtung empfangen wird.

13. Verfahren nach Anspruch 12, ferner aufweisend die folgenden Schritte:
- Detektieren eines DC-Spannungszustands des DC-Spannung-Busses;
- Einspeisen der DC-Spannung in den DC-Spannung-Bus in Abhängigkeit von dem detektierten DC-Spannungszustand.

14. Verfahren nach Anspruch 12 oder 13, ferner aufweisend den Schritt einer Kommunikation mit der elektrischen Energieeinspeisungseinrichtung über den DC-Spannung-Bus unter Verwendung einer Strom empfangenden Verbindung des DC-Spannung-Busses.

## Revendications

1. Système électrique (1) comprenant :
- un bus de tension continue (2) ;
- au moins un agencement d'alimentation en énergie électrique configuré pour fournir une tension continue audit bus de tension continue, dans lequel ledit bus de tension continue est agencé pour transporter ladite tension continue fournie dudit agencement d'alimentation en énergie électrique ;
**caractérisé en ce que**
- le système comprend en outre une source de puissance (5) connectée audit bus de tension continue et agencée pour fournir de la puissance par l'intermédiaire dudit bus de tension continue audit agencement d'alimentation en énergie électrique, dans lequel ledit agencement d'alimentation en énergie électrique est configuré pour recevoir de la puissance en provenance de ladite source de puissance par l'intermédiaire dudit bus de tension continue et pour fournir ladite tension continue audit bus de tension continue uniquement pendant la réception de ladite puissance en provenance de ladite source de puissance par l'intermédiaire dudit bus de tension continue.

2. Système électrique selon la revendication 1, comprenant en outre un agencement de demande d'énergie électrique configuré pour demander une tension continue à partir dudit bus de tension continue (2), dans lequel ledit agencement de demande d'énergie électrique est configuré pour recevoir de la puissance en provenance de ladite source de puissance (5) par l'intermédiaire dudit bus de tension continue et pour demander ladite tension continue à partir dudit bus de tension continue uniquement pendant la réception de ladite puissance.

3. Système électrique selon la revendication 1 ou 2, dans lequel ledit agencement d'alimentation en énergie électrique comprend une source d'énergie durable.

4. Système électrique selon l'une ou plusieurs des revendications précédentes, dans lequel ledit système comprend un convertisseur continu/alternatif connecté audit bus de tension continue et agencé pour recevoir ladite tension continue par l'intermédiaire dudit bus de tension continue et pour convertir ladite tension continue en une tension alternative.

5. Système électrique selon la revendication 4, dans lequel ladite source de puissance est une source de puissance du convertisseur continu/alternatif.

6. Système électrique selon l'une ou plusieurs des revendications précédentes, dans lequel ledit agencement d'alimentation en énergie électrique comprend un contrôleur configuré pour surveiller ladite puissance reçue en provenance de ladite source de puissance par l'intermédiaire dudit bus de tension continue et pour déconnecter ledit agencement d'alimentation en énergie électrique dudit bus de tension continue de sorte qu'aucune tension continue ne soit fournie audit bus de tension continue s'il est décelé que la puissance est absente sur ledit bus de tension continue.

7. Système électrique selon l'une ou plusieurs des revendications précédentes, dans lequel ledit agencement d'alimentation en énergie électrique comprend un capteur configuré pour détecter un état de tension continue dudit bus de tension continue et dans lequel ledit agencement d'alimentation en énergie électrique est configuré pour fournir ladite tension continue audit bus de tension continue en fonction dudit état de tension continue détecté.

8. Système électrique selon l'une ou plusieurs des revendications précédentes, ledit bus de tension continue comprenant des connexions distinctes pour fournir ladite tension continue et pour transporter ladite puissance, dans lequel ledit agencement d'alimentation en énergie électrique comprend un connecteur à connecter audit bus de tension continue, ledit connecteur comprenant un contact étant configuré, lors de la connexion, pour établir un contact avec ladite connexion pour transporter ladite puissance après sa connexion auxdites connexions pour fournir ladite tension continue, et pour se déconnecter de ladite connexion pour transporter ladite puissance avant sa déconnexion desdites connexions pour fournir ladite tension continue.

9. Système électrique selon l'une ou plusieurs des revendications précédentes, dans lequel ledit agencement d'alimentation en énergie électrique comprend un premier module photovoltaïque et un second module photovoltaïque en une chaîne, lesdits premier module photovoltaïque et second module photovoltaïque étant électriquement connectés en dérivation et agencés pour fournir ladite tension continue audit bus de tension continue.

10. Système électrique selon l'une ou plusieurs des revendications précédentes, dans lequel ledit agencement d'alimentation en énergie électrique comprend un convertisseur élévateur de tension continue pour fournir ladite tension continue audit bus de tension continue, ledit convertisseur élévateur de tension continue comprenant optionnellement un transformateur avec un agencement de bobines commutées.

11. Système électrique selon l'une ou plusieurs des revendications précédentes, dans lequel ledit agencement d'alimentation en énergie électrique est configuré pour communiquer par l'intermédiaire dudit bus de tension continue à l'aide d'une connexion pour recevoir ladite puissance.

12. Procédé de fonctionnement d'un système électrique (1) comprenant :
- un bus de tension continue (2) ;
- un agencement d'alimentation en énergie électrique configuré pour fournir une tension continue audit bus de tension continue ;
**caractérisé par**
- une source de puissance (5) connectée audit bus de tension continue et agencée pour fournir de la puissance par l'intermédiaire dudit bus de tension continue audit agencement d'alimentation en énergie électrique ; le procédé comprenant l'étape de :
la fourniture de ladite tension continue en provenance dudit agencement d'alimentation en énergie électrique par l'intermédiaire dudit bus de tension continue uniquement si ladite puissance est reçue en provenance de ladite source de puissance au niveau dudit agencement d'alimentation en énergie électrique par l'intermédiaire dudit bus de tension continue.

13. Procédé selon la revendication 12, comprenant en outre les étapes de :
- la détection d'un état de tension continue dudit bus de tension continue ;
- la fourniture de ladite tension continue audit bus de tension continue en fonction dudit état de tension continue détecté.

14. Procédé selon les revendications 12 ou 13, comprenant en outre l'étape de la communication par l'intermédiaire dudit bus de tension continue avec ledit agencement d'alimentation en énergie électrique à l'aide d'une connexion dudit bus de tension continue pour recevoir ladite puissance.
